Europäisches Patentamt

European Patent Office

Office européen des brevets

(11) Publication number: 0 162 541
A1

# EUROPEAN PATENT APPLICATION

(21) Application number: 85301906.5

(22) Date of filing: 19.03.85

(51) Int. Cl.⁴: H 01 L 27/14

(30) Priority: 28.03.84 US 594089

(43) Date of publication of application:
27.11.85 Bulletin 85/48

(84) Designated Contracting States:
DE FR GB IT NL

(71) Applicant: International Standard Electric Corporation
320 Park Avenue
New York New York 10022(US)

(72) Inventor: Ghosh, Chuni Lal
5954 Merriman Road
Roanoke Viginia 24018(US)

(72) Inventor: Phatak, Sunil Bhaskar
7216 Longleaf Drive N.W
Roanoke Viginia 24019(US)

(74) Representative: Ruffhead, Philip Geoffrey
ITT-UK Patent Department Maidstone Road Foots Cray
Sidcup DA14 5HT(GB)

(54) Integrated heterojunction FET and photodiode.

(57) A semiconductor device includes at least one photosensitive diode and at least one transistor on a common substrate. The substrate (1) is of a semi-insulating InP material, and a layer (2) of n-type InGaAs is provided on one of the major surfaces of the substrate. As shown, the device is constructed as a JFET/junction diode combination, in which case formations (3 and 4) of a p-type material, especially p-type InGaAs or p-type InP, are provided on the n-type InGaAs layer both for the respective diode and the respective transistor. Respective contact metallisation (5 and 6) are provided on the top of both types of formations, and source and drain contacts (7 and 8) are provided on the n-type InGaAs layer at opposite sides of the respective transistor formation, while a diode contact (9) is arranged on the n-type InGaAs layer next to the formation for the diode. Since the substrate is transparent to infrared radiation in a predetermined wavelength range used in optical fibre communication, and the n-type InGaAs layer absorbs such radiation, the light directed against the diode region through the substrate will cause change in the current flow through the diode, so that the output of the diode is proportional to the intensity of the light reaching the diode. The invention can also be applied to a MESFET/Schottky diode combination device.

Fig.1.

## SEMICONDUCTOR DEVICE

The present invention relates to semiconductor devices in general, and more particularly to semiconductor devices incorporating indium gallium arsenide.

There are already known various constructions of semiconductor devices, usually made of silicon which is doped with various dopants to provide regions of different conductivity types. Also, various methods have been developed for fabricating such silicon semiconductor devices. However, experience has shown that such devices are rather slow because of the relatively low carrier mobility in silicon. On the other hand, attempts have been made to make semiconductor devices by using gallium arsenide, and some high speed semiconductor devices have already been made using this material. Such devices are distinguished by speeds which are much higher than those achievable with similar devices made of silicon. However, experience has shown that even such gallium arsenide devices do not have the speed which is currently desired, for instance, for high speed communications.

Moreover, conventional approaches do not readily lend themselves to the fabrication of photosensitive devices and transistors on the same chip, which is highly desirable especially in optical fibre communications.

Accordingly, it is the object of the present invention to avoid the disadvantages of the prior art.

It is another object of the invention to provide a semiconductor device which does not possess the above-enumerated disadvantages of known semiconductor devices.

Another object of the invention is so to construct the semiconductor device that it is able to operate at very high speeds.

Another object of the invention is so to design the semiconductor device that it is usable in a system using light, especially infrared light, as a transmission medium.

Another object of the invention is to develop a one-chip transistor/photosensitive diode combination.

In accordance with the invention in its broadest aspect, there is provided a light-responsive heterojunction semiconductor device comprising a common substrate of a semiconductor material that is at least translucent to light in a predetermined wavelength range, said substrate having two major surfaces, and at least one field effect transistor and at least one light-sensitive diode commonly provided on said substrate, characterised in that the device is constituted by a layer of n-type InGaAs on one of the major surfaces of the substrate, one raised formation of a semiconductor material of one conductivity type for both the transistor and diode on the layer, a metallic contact on each of the formations, source and drain contacts on the layer at mutually opposite sides of one of the formations for forming the transistor therewith, and a diode contact on the layer adjacent to the other of the formations for forming therewith the diode that is sensitive to light in the predetermined wavelength range directed against the other of the major surfaces of the substrate and penetrating through the substrate into the layer at the region of the diode.

A particular advantage of the construction of the semiconductor device as described so far is that indium gallium arsenide has even higher electron mobility than gallium arsenide, so that devices fabricated out of this material have much higher speeds than known heretofore. Moreoever, this material has a lower band gap than gallium arsenide and, therefore, it is possible to fabricate semiconductor devices with lower resistivity ohmic contacts, higher transconductance, and lower noise, from this material. Moreover, because the band gap can be tailored by changing the composition of the material, such devices could also be used as infrared detectors in the regions of approximately 1.3 microns and 1.55 microns, which are the wavelengths at which lasers employed in fibre optic communication operate.

Embodiments of the invention will now be described by way of example with reference to the accompanying drawings, in which:

Figure 1 is a considerably-enlarged cross sectional view through a semiconductor device according to the present invention constructed as a combination of a junction field effect transistor (JFET) and a junction diode; and

Figure 2 is a view similar to that of Figure 1 but with the device being constructed as a combination of a MESFET with a Schottky diode.

The semiconductor device of the present invention can be constructed either as a

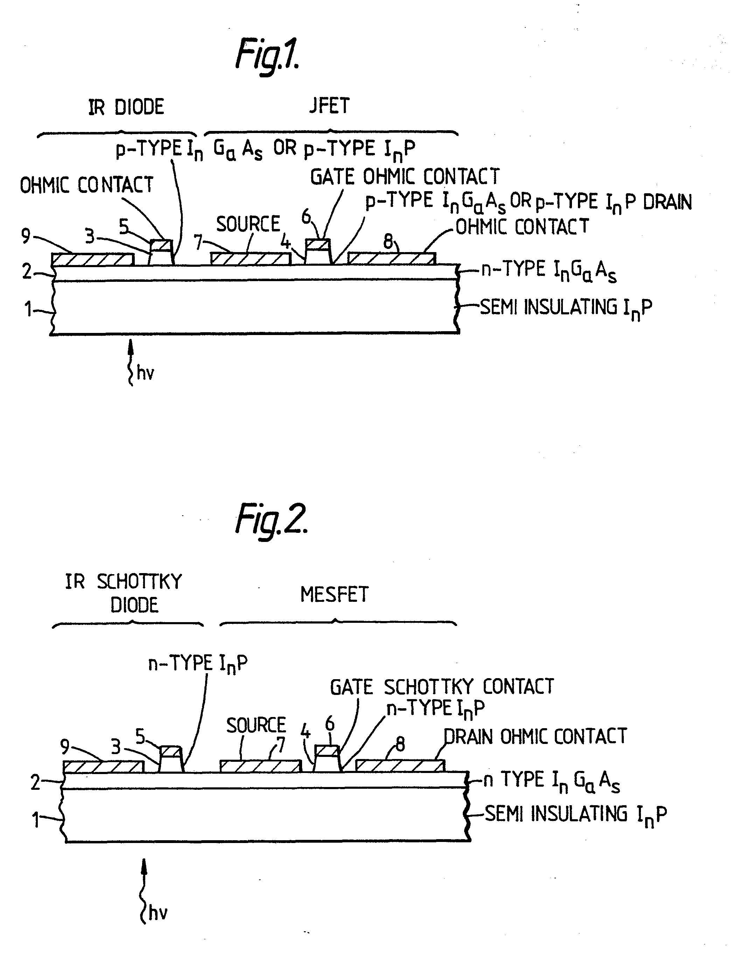

combination of a JFET with a junction diode or as a combination of a MESFET with a Schottky diode. In each instance, as a comparison of Figures 1 and 2 of the drawing will reveal, the device includes a substrate 1 of an insulating or semi-insulating InP, and a thin layer 2 of an n-type InGaAs on one of the major surfaces of the substrate 1.

When the device is to be constructed as a combination of a junction diode and a JFET, then, as shown in Figure 1, a formation 3 for the junction diode, and a formation 4 for the JFET are provided on the layer 2 in a manner to be discussed later, the formations 3 and 4 being of a p-type material, especially p-type InGaAs or p-type InP. The formations 3 and 4 are provided at their top surfaces with ohmic contacts 5 and 6, respectively. Source and drain contacts 7 and 8 are arranged on the layer 2 at mutually-opposite sides of the formation 4 to form the JFET therewith. Furthermore, a diode contact 9 is arranged on the layer 2 next to the formation 3 and at the opposite side thereof from the source contact 7 of the JFET, to form the diode with the formation 3. The diode thus obtained can be used as a photodetector, since it is sensitive to light in the infrared range that is used, for instance, in optical fibre communication systems. The substrate 1 is transparent to light in this range so that any light in this range that is directed, as indicated by an arrow, against the major surface of the substrate 1 that faces away from the layer 2, will pass through the substrate 1 and reach the layer 2 at the region of the formation 3, and influence the operation of the diode so that its output will be proportionate to the intensity of such light. This output can then be used to control the operation of the JFET described above and provided in the same substrate 1, so as to achieve amplification or the like.

On the other hand, when the device is to be constructed as a combination of MESFET with a Schottky diode, then the approach revealed in Figure 2 is used. Since the structure of this device is similar to that described above, the same reference numerals as before have been used to identify corresponding elements or parts. Here again, as mentioned above, the layer 2 of n-type InGaAs is provided on one of the major surfaces of the insulating or semi-insulating InP substrate 1. In contradistinction with what was discussed before, however, in this instance the formations 3 and 4 are made of n-type material, especially n-type InP, in a manner to be discussed later. Then, the contacts 5 and 6 provided on the top surfaces of the formations 3 and 4, respectively, are Schottky contacts. Of course, the source and drain contacts 7 and 8, and the diode contact 9, are also provided on the layer 2 at the appropriate locations even in this instance. The diode can again be used as a photodetector, in the same manner as discussed above.

Having thus described the structure and composition of the devices, it will now be explained how such devices can be manufactured. In each instance, the fabrication is commenced by growing the thin layer 2 of n-type InGaAs on the insulating InP substrate. This layer 2 has a thickness of substantially between .2 and .3 microns. The further fabricating steps, even though akin to one another, will differ for the JFET/junction diode combination and for the MESFET/Schottky diode combination, so that they will hereafter be discussed separately.

Starting with the fabrication of a JFET/junction diode combination, the next step after the formation of the n-type InGaAs layer 2 is the growth of a p-type layer of either InGaAs or of InP on the n-type InGaAs layer 2. The thickness of this p-type layer is approximately .2 to .3 microns.

After the growth of the p-type layer on the n-type InGaAs layer 2, metallisation may be defined on the p-type layer by photolithography. Next, the metallisation is formed on the desired region by evaporation of metals such as chromium followed by gold, these metals being suited for making ohmic contact to the p-type InGaAs and to the p-type InP as well. Thereafter, a protective layer of silicon dioxide is deposited on the metallisation.

Following the above steps, regions of the projecting formations 3 and 4 are defined by using conventional techniques, such as photolithography, and the material around such formation regions is etched either with a chemical etchant or by using plasma etching. When the p-type material is InGaAs, the progress of the etching is monitored very carefully and the etching is discontinued when the p type layer of InGaAs has been removed at all other regions except beneath the gate metallisation. On the other hand, when the p-type material is InP, a selective etch is used which etches InP but does not etch InGaAs, so that the etching stops when the InGaAs layer is reached. Obviously what remains after the conclusion of this etching are the formations 3 and 4.

In the next step, the source and drain contacts 7 and 8 as well as the diode contact 9 are formed on the n-type InGaAs layer 2 by first resorting to the well known photolithographic technique, and then depositing the ohmic contact metallisation, such as AuGe/Ni. The device thus obtained is then put through a thermal cycle for alloying the projecting formation metallisations 5 and 6 as well as the source, drain and diode metallisations 7, 8 and 9. Finally, the aforementioned SiO$_2$ layer covering the contact metallisations 5 and 6 is removed by a short rinse in a diluted hydrochloric acid.

As mentioned before, the indium phosphite substrate 1 is transparent to infrared radiation in the range between approximately 1.2 and 1.6 microns which is used nowadays in optical fibre communication. On the other hand, the n-type InGaAs absorbs such radiation with attendant change in the flow of electric current between the contact 5 and the diode contact 9 in dependence on the intensity of the radiation, provided that such radiation is directed through the substrate 1 toward the region of the formation 3. Hence, in such circumstances, the output of the junction diode will be proportional to the intensity of such radiation.

In a variation of the process, a layer of silicon dioxide is deposited on the layer 2 of n-type InGaAs before any other deposition takes place. Then, the regions for the formations 3 and 4 are opened in the silicon dioxide layer by etching or lift-off. The p-type InGaAs or InP is then grown on these areas by selective epitaxy. Then, the following steps are performed in the same manner as described above, starting with the deposition of the gate metallisations 5 and 6.

When the device to be fabricated is to be a combination of a MESFET with a Schottky diode, which would normally not be possible on InGaAs provided on a lower band gap material because the Schottky barrier height would be too low, in the order of about .3ev, it is advantageous to proceed according to the present invention in the following manner:

A lattice matched InP of the n-conductivity type, lightly doped, is grown on the previously provided layer 2 of n-type InGaAs. This n-type layer increases the Schottky barrier height.

In the next step, metallisation is defined on the n-type InP. In this instance, the metallisation which is deposited consists of such materials as aluminium or Mo/Au which do not react with InP at high temperatures. Thereafter, the metallisation is protected by a layer of silicon dioxide on top. The incomplete device thus formed is then etched by a selective etch to remove the InP layer everywhere but underneath the metallisation. When the thin layer of InP is completely etched except that those regions that are situated below the metallisation and that constitute the formations 3 and 4, metallisation for the diode contact 9 and metallisations for the source and drain contacts 7 and 8 are defined by evaporating material such as Au/Ge/Ni on the layer 2 of n-type InGaAs and alloying it at a high temperature. The fabrication of the device is then completed by etching the silicon dioxide protective layer from the formation metallisations 5 and 6, similarly to what has been described above in connection with the JFET/junction diode combination.

Here again, the formations 3 and 4 may be fabricated in the manner described above as an alternative, that is, by depositing a layer of $SiO_2$ on the layer 2 of n-type InGaAs, by opening windows at the desired formation regions by lift-off or chemical etching, and by growing n-type InP in the open areas by selective epitaxy. Of course, here again, the following steps commencing with deposition of the metallisation will be the same as in the above-discussed process. The MESFET/Schottky diode combination device constructed in this manner is also suitable for use as a photodetector, for the same reasons as discussed above in connection with the JFET/junction diode combination device, and in the same manner.

The various steps discussed above are known in principle, even though used in prior art to form different devices. Therefore, it is not necessary to discuss such steps, such as photolithography, lift-off, growing of material layers, etching, and the like, here, since such individual steps are well known to those active in this field. On the other hand, the devices incorporating specific materials at specified regions are unique to the present invention.

CLAIMS:

1. A light-responsive heterojunction semiconductor device comprising a common substrate of a semiconductor material that is at least translucent to light in a predetermined wavelength range, said substrate having two major surfaces, and at least one field effect transistor and at least one light-sensitive diode commonly provided on said substrate, characterised in that the device is constituted by a layer of n-type InGaAs on one of the major surfaces of the substrate, one raised formation of a semiconductor material of one conductivity type for both the transistor and diode on the layer, a metallic contact on each of the formations, source and drain contacts on the layer at mutually opposite sides of one of the formations for forming the transistor therewith, and a diode contact on the layer adjacent to the other of the formations for forming therewith the diode that is sensitive to light in the predetermined wavelength range directed against the other of the major surfaces of the substrate and penetrating through the substrate into the layer at the region of the diode.

2. A semiconductor device as claimed in claim 1, characterised in that the substrate is of a substantially insulating InP.

3. A semiconductor device as claimed in claim 1, characterised in that the one conductivity type of the semiconductor material of the raised formations is the p-type.

4. A semiconductor device as claimed in claim 3, characterised in that the semiconductor material of the raised formations is InP.

5. A semiconductor device as claimed in

- 11 -                    0162541

claim 3, characterised in that the semiconductor material of the raised formations is InGaAs.

6. A semiconductor device as claimed in claim 1, characterised in that one conductivity type of the semiconductor material of the raised formations is the n-type.

7. A semiconductor device as claimed in claim 6, characterised in that the semiconductor material of the raised formations is InP.

8. A semiconductor device as claimed in claim 1, characterised in that the other formation is arranged adjacent to and spaced from the source contact; and in that the diode contact is situated on the opposite side of the other formation from the source contact.

## Fig.1.

IR DIODE        JFET

p-TYPE $I_n G_a A_s$ OR p-TYPE $I_n P$

OHMIC CONTACT     GATE OHMIC CONTACT

             p-TYPE $I_n G_a A_s$ OR p-TYPE $I_n P$ DRAIN

            SOURCE    6         OHMIC CONTACT

9    3   5      7      4     8

2                             n-TYPE $I_n G_a A_s$

1                           SEMI INSULATING $I_n P$

$\{h\nu$

## Fig.2.

IR SCHOTTKY         MESFET
DIODE

n-TYPE $I_n P$

                  GATE SCHOTTKY CONTACT
                  n-TYPE $I_n P$

      SOURCE   4   6        DRAIN OHMIC CONTACT

9   3   5        7      8

2                           n TYPE $I_n G_a A_s$

1                           SEMI INSULATING $I_n P$

$\{h\nu$

European Patent
Office

**EUROPEAN SEARCH REPORT**

0162541
Application number

EP 85 30 1906

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | PATENTS ABSTRACTS OF JAPAN, vol. 7, no. 284(E-217)[1429], 17th December 1983; & JP - A - 58 161 366 (FUJITSU K.K.) 24-09-1983<br>--- | 1,2,6, 7 | H 01 L 27/14 |
| Y | EP-A-0 073 889 (LICENTIA PATENT-VERWALTUNGS GmbH)<br>* Figure 3 *<br>--- | 1,5-7 | |
| Y | ELECTRONICS LETTERS, vol. 16, no. 10, 8th May 1980, pages 353-355, Hitchin, GB; R.F. LEHENY et al.: "Integrated In0.53Ga0.47As p-i-n F.E.T. photoreceiver"<br>* Page 354, left-hand column *<br>--- | 1-3,5 | |
| A | INTERNATIONAL ELECTRON DEVICES MEETING, 7th-9th December 1981, Technical Digest, pages 276-279, IEEE, New York, US; R.F. LEHENY et al.: "An integrated PIN/JFET photoreceiver for long wavelength optical systems"<br>* Page 276, right-hand column, section: "Fabrication" *<br>--- | 1-3,5 | TECHNICAL FIELDS SEARCHED (Int. Cl.4)<br><br>H 01 L |
| A | INTERNATIONAL ELECTRON DEVICES MEETING, Washington, D.C., 8th-10th December 1980; Technical Digest, pages 434-436, IEEE, New York , US; H. OHNO et al.: "Double heterojunction GaInAs devices by MBE"<br>* Page 435, sections 4,6; figure 1a *<br>--- -/- | 1,2 | |

The present search report has been drawn up for all claims

| Place of search | Date of completion of the search | Examiner |
|---|---|---|
| THE HAGUE | 27-06-1985 | PRETZEL B.C. |

**European Patent Office**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | ELECTRONICS INTERNATIONAL, vol. 56, no. 7, 7th April 1983, pages 88-90, New York, US; R.T. GALLAGHER: "Single process for FETs and transistors may lead to single-chip GaAs photoreceivers" * Figures * | 1-3,5 | |
| A | INTERNATIONAL ELECTRON DEVICES MEETING, Washington, D.C., 7th-9th December 1981, Technical Digest, pages 96-99, IEEE, New York, US; A.Y. CHO et al.: "An In0.53Ga0.47As very shallow junction gate structure grown by molecular beam epitaxy for field effect transistor applications" * Figure 5 * | 1-3,5 | |
| A | EP-A-0 055 968 (THOMSON-CSF) * Figure 9; claims 4,7,8 * | 1,2,6, 7 | TECHNICAL FIELDS SEARCHED (Int. Cl.4) |

The present search report has been drawn up for all claims

| Place of search | Date of completion of the search | Examiner |
|---|---|---|
| THE HAGUE | 27-06-1985 | PRETZEL B.C. |